Europäisches Patentamt

**European Patent Office**

**Office européen des brevets**

(11) Veröffentlichungsnummer: **0 327 718**

**A2**

(12) **EUROPÄISCHE PATENTANMELDUNG**

(21) Anmeldenummer: **88121371.4**

(22) Anmeldetag: **21.12.88**

(51) Int. Cl.4: **H01L 21/324**

(30) Priorität: **11.02.88 DE 8801785 U**

(43) Veröffentlichungstag der Anmeldung:
**16.08.89 Patentblatt 89/33**

(84) Benannte Vertragsstaaten:
**AT BE CH DE ES FR GB GR IT LI LU NL SE**

(71) Anmelder: **Söhlbrand, Heinrich Dr.,
Wirtsbauernstr. 26
D-8027 Neuried b. München(DE)**

(72) Erfinder: **Söhlbrand, Heinrich Dr.,
Wirtsbauernstr. 26
D-8027 Neuried b. München(DE)**

(54) Verfahren und Vorrichtung zur Temperaturbehandlung von Halbleitermaterialien.

㊗ Mit der Erfindung wird ein Verfahren und eine Vorrichtung zur Wärmebehandlung von Halbleitermaterialien vorgeschlagen, die ein isothermales, allseits beheiztes Prozessrohr im sogen. "closed-tube" Verfahren unter Anwendung einer kompakten Bauweise des Ofens beinhaltet, wobei eine definierte Prozessgasatmosphäre von Prozessbeginn an in dem Prozessraum herrscht und eine Rückdiffusion vermieden wird. Es findet ein Doppelrohrsystem Anwendung mit einer regelbaren Zwischenraumspülung, d.h. Einsatz der sogen. "schnellen Kassette" zum Kaltblasen. Anwendungsbereiche der Erfindung sind insbesondere Oxydation, Diffusion, Deposition und Tempern von Halbleiterscheiben.

Fig.1

EP 0 327 718 A2

## VERFAHREN UND VORRICHTUNG ZUR TEMPERATURBEHANDLUNG VON HALBLEITERMATERIALIEN

Die Erfindung bezieht sich auf ein Verfahren und eine Vorrichtung zur Temperaturbehandlung von Halbleitermaterialien, insbesondere zur Nieder- , Mittel- und Hochtemperaturbehandlung mittels eines Diffusionsofens, der ein beladeseitig offenes, doppelwandiges Prozessrohr enthält, mit einer im zwischen den Rohrwandungen verbleibenden Ringraum vorgesehenen Fluidspülung, einer Cantileveranordnung für das Einbringen der zu behandelnden Halbleiterscheiben in das Prozessrohr und einer Prozessgaseinspeisung am hinteren Ende des Prozessrohres mit beladeseitiger Entsorgung dieser Gase.

Solche Verfahren und Vorrichtungen zur Temperaturbehandlung von Halbleitermaterialien, allgemein als Diffusionsöfen bezeichnet, sind an sich bekannt. Die Diffusionsöfen, meist als Horizontaldiffusionsöfen ausgebildet, dienen der Oxydation, Diffusion, Abscheidung und Temperung von Scheiben aus Halbleitermaterialien. Dabei werden die Halbleiterscheiben auf besonderen Vorrichtungen, als Cantilever bezeichnet, in ein Quarzrohr oder ein Rohr aus Si, bsw. SiC, das als Prozessrohr bezeichnet wird und die Innenwand des Diffusionsofens bildet, eingebracht und darin einer Temperaturbehandlung ausgesetzt. Die Cantilever führen mit den darauf angeordneten Halbleiterscheiben eine zum Rohr koaxiale Lateralbewegung aus, bei der die in das Prozessrohr einzubringenden Halbleiterscheiben das Rohr selbst niemals berühren.

Nach dem Einbringen in das Prozessrohr werden die Halbleiterscheiben von Anfang an hohen Temperaturen ausgesetzt, die bereits die eigentlichen Prozesstemperaturen sein können, bzw. die untere Haltetemperatur mit Werten zwischen 700 bis 800° C ist.

Diese bekannten Diffusionsöfen sind jedoch mit verschiedenen Nachteilen behaftet. Der Hauptgrund dafür ist die fehlende Anpassung der Öfen selbst, also der Vorrichtungen, an die angewandten Verfahren. So werden die Halbleiterscheiben auf diese Temperatur rasch und unkontrolliert erwärmt. Die Halbleiterscheiben werden dann, der jeweiligen Technologie folgend, mittels Verdrängungsspülung der eigentlichen gewünschten Prozessatmosphäre ausgesetzt, wobei das Prozessrohr nie vollständig, also zu 100%, dicht verschlossen werden kann. Dies hat zur Folge, daß zu einer unvollständigen Verdrängungsspülung noch zusätzlich Rückdiffusion wirksam wird und somit die Prozessgasatmosphäre stets undefiniert hinsichtlich Ort, Zusammensetzung und Zeit ist. Eine Reproduzierbarkeit des durchgeführten Verfahrens ist dadurch unmöglich, was zu gravierenden technologischen Nachteilen führt. Dies findet dann seinen Niederschlag in mangelnder Funktionalität, Ausbeute und Betriebssicherheit der solcherart behandelten Halbleiterscheiben. Ein weiterer Nachteil der bekannten Diffusionsöfen liegt darin, daß nur ein ringförmiger Heizkörper um das Prozessrohr vorgesehen ist, der zu unkontrollierten Temperaturverhältnissen im Prozessraum führt.

Es wurden bereits Versuche unternommen, diese Nachteile zu beheben, indem Inertgasschleusen am offenen Ende des Prozessrohres vorgesehen wurden. Diese Maßnahme hatte jedoch nur unbefriedigende Verbesserungen des Verfahrensablaufes zur Folge.

Auch der Gegenstand der DE C1 35 39 981 bringt keine Verbesserung; denn der Austausch der Prozeßgase würde viel zu lange dauern, um ein Verfahren wirtschaftlich durchführen zu können. Standzeiten bis zu mehreren Tagen wären nötig, bis ein neuer Prozeßablauf eingeleitet werden kann.

Hier will die Erfindung Abhilfe schaffen. Die Erfindung, wie sie in den Ansprüchen gekennzeichnet ist. löst die Aufgabe, einen Diffusionsofen zu schaffen, der dem Verfahrensablauf angepasst ist, in dessen Reaktionsraum Isothermie herrscht, keine Energieverluste durch Abstrahlung auftreten, jedwelche Schwermetallkontamination der zu behandelnden Halbleiterscheiben vermieden. wird, eine eindeutig definierte Prozessgasatmosphäre bereits bei Temperaturen unter 400° C herrscht und Prozesstemperaturen in einem weiten Bereich zur Anwendung kommen können und in dem Halbleiterscheiben aus mono- oder polykristallinem Silizium oder mono- bsw. polykristallinem Silizium auf beliebigen Trägermaterialien, sowie anderen Halbleitermaterialien behandelt werden können.

Mit der Erfindung werden mehrere Vorteile erzielt. So wird das Prozessrohr vollständig verschlossen und eine Abstrahlung von Energie vermieden, außerdem eine möglich Schwermetallkontamination durch den Einbau eines Doppelwandrohres mit permanenter Inertgasspülung vermieden, sowie eine eindeutig definierte Prozeßgasatmosphäre bereits bei Temperaturen unter 400° C durch die Anwendung eines "soft-pump-down steps" bei absolut dichtem Verschluß des Prozessrohres erzielt und die Einspeisung der Prozessgase beladeseitig bei gleichzeitiger Vorwärmung durch ein in den Cantilever integriertes, fahrbares Heizelement ermöglicht. Ein weiterer Vorteil liegt darin, daß das Prozessrohr an seinem offenen Ende aufgeweitet ist und von dem Vestibülblock so umschlossen wird, daß die Abstrahlung von Energie eliminiert ist, wodurch Arbeitstemperaturen in einem Bereich von etwa Raumtemperatur bis 1300° C gefahren werden können.

Die Erfindung ist nachstehend anhand der in den Abbildungen dargestellten Ausführungsbeispiele näher erläutert.

Es zeigt:

Fig. 1 einen Längsschnitt durch die erfindungsgemäße Vorrichtung,

Fig. 2 einen Schnitt durch eine Ausführungsvariante des Cantilevers,

Fig. 3 einen Schnitt durch die Fig.2,

Fig. 4 eine weitere Ausführungsvariante der Fig.2 und

Fig. 5 eine Ausführungsvariante der Fig.1

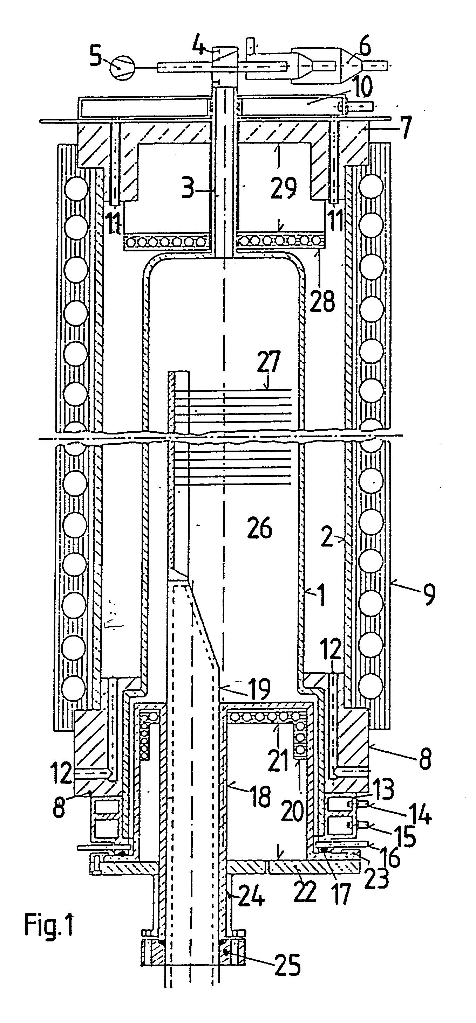

Die in Fig.1 im Schnitt dargestellte Vorrichtung ist ein sogen. Diffusionsofen zur Wärmebehandlung von Halbleiterscheiben. Der Diffusionsofen besteht im wesentlichen aus einem Prozessrohr 1, das gleichzeitig die Innenwandung des Diffusionsofens ist und einem äusseren Rohr 2, welches mittels der Vestibülblöcke 7 und 8 in seiner Lage zum Prozessrohr 1 und der Heizkassette 9 festgelegt ist. Dieses Prozessrohr 1 ist an seinem offenen, beladeseitigen Ende (rechts im Bild) aufgeweitet, während es sich an seinem linken Ende, zum Gasauslaßrohr 3 hin, verjüngt. Die Gasentsorgung des Prozessrohres 1 erfolgt entweder über ein Drei-Wege Ventil 4 und eine Pumpstation 5 oder ein besonderes Exhaustsystem mit N -Schleuse 6. Die beiden Rohre 1 und 2 bilden somit ein fixiertes Doppelwandrohrsystem. Das Innen- und das Außenrohr besteht vorzugsweise aus Quarz, Si, SiC, $Al_2 O_3$, polykristallinem Si oder einer anderen, halbleitertauglichen Materie, die eine Formsteifigkeit bis 1300 °C besitzt, wobei sich $Al_2 O_3$ für das Innenrohr 1 weniger eignet. Da keinerlei feste, d.h. geschweißte Verbindungen zwischen den beiden Rohren 1 und 2 bestehen, entfällt die Notwendigkeit, daß beide aus identischem Material bestehen.

Der Vestibülblock 7 ist axial federnd vorgesehen, um den temperaturbedingten Bewegungen des Prozessrohres 1 folgen zu können, während der Vestibülblock 8 starr angeordnet ist. Die Cantileveranordnung 18-25 wird zum Ein- und Ausfahren axial bewegt. Die Vestibülblöcke sind vorzugsweise aus Graphit mit BN-Coating gefertigt. Auf diese Weise wird sowohl eine absolute Resistenz gegen Temperaturstreß und absolute Reinraumtauglichkeit erreicht.

Die Inertgaseinspeisung 10 ist mit einem Kranz von Einlaßdüsen 11 im Vestibülblock 7 verbunden, wodurch der Raum zwischen den Rohren 1 und 2 ständig, d.h. während der Prozessphase und im stand-by Betrieb, gespült wird. Auf diese Weise wird eine Kontamination, insbesondere mit Schwermetallen, aus dem Heizkassettenbereich vermieden. Die Spülgase verlassen durch einen weiteren Kranz von Auslaßdüsen 12 im Vestibülblock 8 das Rohrsystem wieder.

Der Vestibülblock 8 dient gleichzeitig auch als Aufnahme und Stützlager für das an seinem offenen Ende erweiterte Prozessrohr 1. Durch diese Maßnahme wird nahezu vollständig eine Wäurmeabstrahlung an der Beladeseite des Diffusionsofen vermieden.

Ein Kühlmantelsystem 13 fügt sich bündig an den Vestibülblock 8 an und bildet den eigentlichen Rohrabschluß. Dieses Kühlmantelsystem enthält ein Luftkühlsystem 14 und ein Wasserkühlsystem 15 sowie die Prozessgaseinspeisung 16. Mittels eines Dichtringes 17 wird das Kühlmantelsystem 13 vakuumdicht gegenüber dem Cantileversystem 18-25 und dem Rohr 1 verschlossen, sowie die Einfahrposition des Cantilevers erreicht ist. Die Prozessgase werden durch die Prozessgaseinspeisung seitlich austretend, in Rotation versetzt und strömen durch den ringförmigen Schlitz, der zwischen dem aufgeweiteten Ende des Prozessrohres 1 und dem Quarzstutzen 18 des Cantileversystems 18-25 verbleibt, in den eingentlichen Reaktionsraum 26 hinein, wobei sie durch das Heizelement 20 bereits vorgewärmt sind.

Das Cantileversystem 18-25 ist in bekannter Weise auf einem in der Abbildung nicht dargestellten, fahrbaren Schlitten mit Montageplattform montiert und besteht, wie in Fig.1 dargestellt, aus einem SiC-Paddle 19, das ebenfalls in bekannter Weise auf einem nicht dargestellten LP-Carrier die zu behandelnden Halbleiterscheiben 27 trägt und außberdem, aufgrund seiner hohen thermischen und mechanischen Belastbarkeit einen Spezialquarzstutzen mit Flansch 18 trägt, in dem ein mitfahrbarendes, den beladeseitigen Querschnitt in der dargestellten Weise ausfüllendes regelbares Heizelement 20 installiert ist. Der verbleibende Hohlraum ist mit Quarzwolle 21 ausgefüllt. Der Stutzen 18 ist mittels einer Metall- oder Keramikplatte 22 mit einem Haltering 23 fixiert. Um einer evtl. möglichen thermischen Überlastung entgegenzuwirken, ist die Platte 22 durch einen formschlüssigen Stutzen 24 mit einem Dichtelement mit O-Ring 25 verbunden und gleichzeitig in seiner Position auf dem SiC-Paddle 19 fixiert.

Ein weiters regelbares Heizelement 28 ist stationär in einem Quarzrohrstutzen im hinteren Vestibülblock 7 vorgesehen, wobei der verbleibende Hohlraum mit Quarzwolle ausgefüllt ist. Mittels dieses Heizelementes 28 sind gasauslaßseitig isothermische Verhältnisse erzielt.

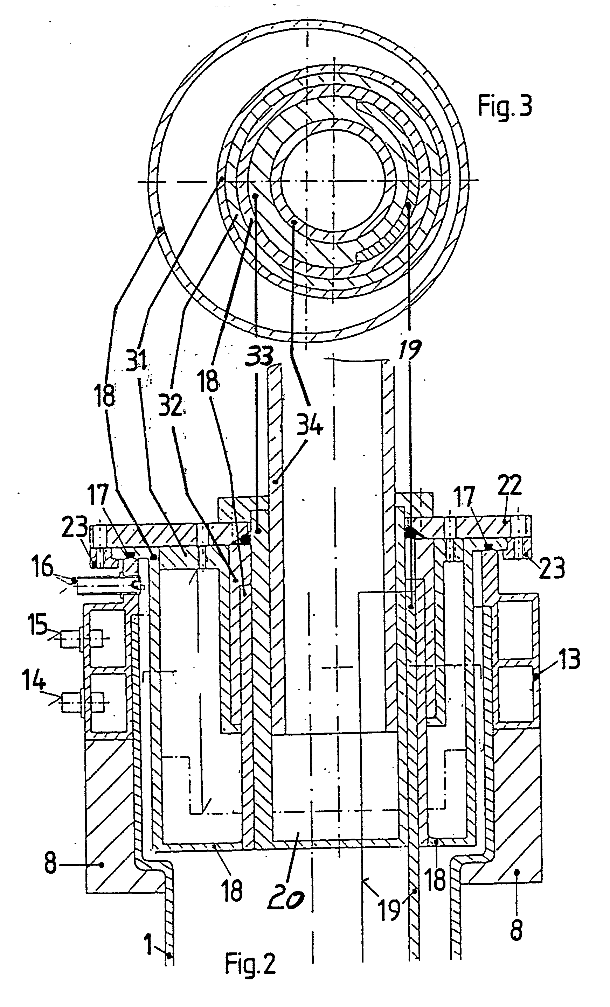

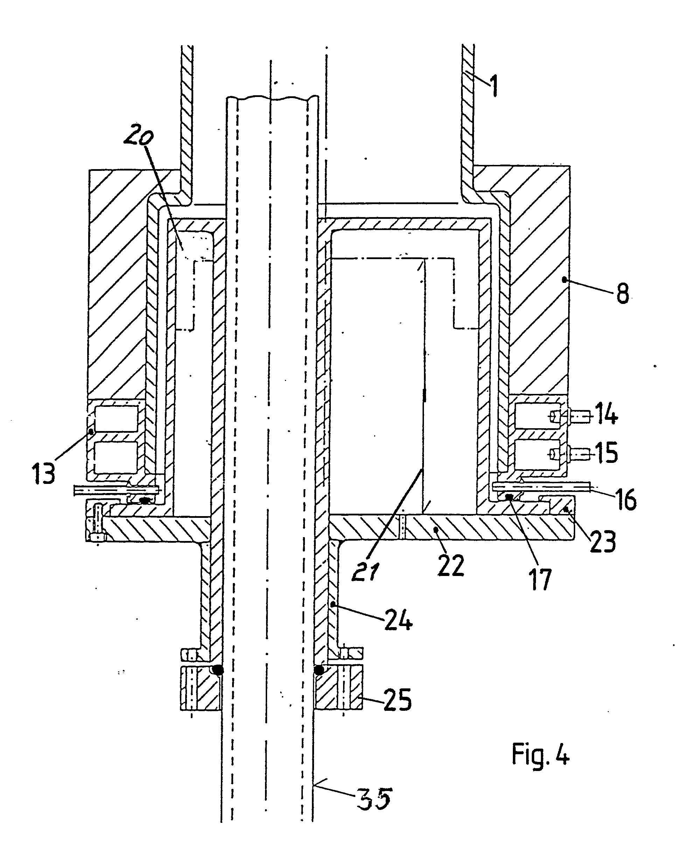

Das Cantileversystem gem. Fig.1 sowie dessen Ausführungsvarianten gem. Fig.2 - 5 bestehen aus formschlüssigen Teilen unterschiedlicher materialien, die jeweils zu einem funktionsfähigem Cantileversystem steckbar sind. Bevorzugte Materialien für die einzelnen Teile des Cantileversystems sind Quarz, polykristallines Silizium, SiC; homogene Gemische aus Quarz, Teflon oder Polyamiden; homogene Gemische aus Quarz und $Al_2O_3$, BN, Si N, polykristallines Si, SiC; oder homogene Gemische aus Teflon bzw. Polyamiden mit $Al_2O_3$, Si N , polykristallines Si, SiC oder dergl.

Die Ausführungsvariante des Cantileversystems gem. Fig.2 und Fig.3 ist mit einer steckbaren Paddle 33,34 ausgerüstet, die einfach austauschbar ist. Eine solche steckbare Paddle ist besonders dann von Vorteil, wenn Prozesse durchgeführt werden, die durch einen hohen Materialstreß gekennzeichnet sind, wie z.B. Abscheideprozesse, Diffusionen usw., wobei dem einfachen Herausziehen der Paddle das Hineinschieben einer neuen Paddle folgt. Diese Maßnahme stellt die Betriebsbereitschaft des Diffusionsofens in kürzester Zeit, etwa 1/2 Minute, wieder her.

Die Ausführungsvariante gem. 4 stellt ein Cantileversystem für spezielle Anwendungsfälle, wie Abscheidungsprozesse oder dergl. dar, wobei der Paddle 35 eine besonders geringe Masse besitzt.

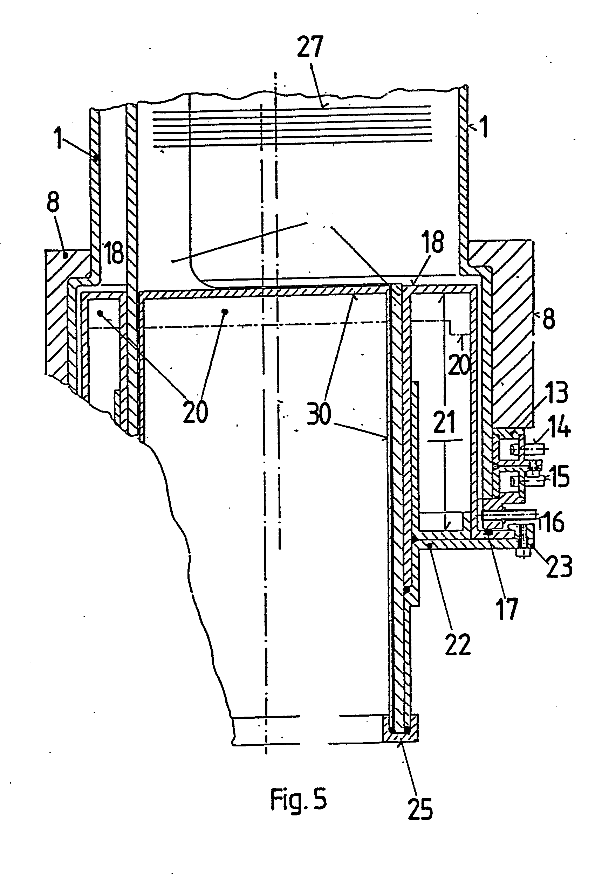

Die Ausführungsvariante gem. Fig.5 eignet sich besonders für Niedertemperaturprozesse, Plasmaabscheidungen, Tempern nach Implantationen, usw. Hierbei ist der Paddle 36 fest verschweißt.

Der erfindungsgemäß ausgebildete Diffusionsofen eignet sich auch, ohne Adaptionsaufwand, zum nachträglichen Einbau in bereits bestehende Diffusionsöfen alter Bauart.       . .

Der Verfahrensablauf ist am Beispiel einer sogen. "Gateoxydation" erläutert, wobei ausdrücklich darauf hingewiesen ist, daß die Gateoxydation nur eines der möglichen Verfahren darstellt die mit der Vorrichtung durchgeführt werden können.

Vor Beginn des eigentlichen Verfahrensablaufes wird die Temperatur der Heizkassette 9 und des Heizelementes 28 auf etwa 300 C und die Temperatur des Heizelementes 20 auf Raumtemperatur gestellt, während die Inertgasspüleinrichtung, bestehend aus der Inertgaseinspeisung 10 mit dem Kranz von Einlaßdüsen 11 und den Auslaßdüsen 12 auf hohen Durchsatz geregelt wird um eine zusätzliche, rasche Kühlung des Reaktionsraumes 26 zu erreichen. Die auf den Cantilever 19 geladenen Halbleiterscheiben 27 werden dann in den Reaktionsraum 26 eingefahren bis sie sich in der in Fig.1 dargestellten Position befinden. Dabei wird über den Dichtring 17 ein vakuumdichter Verschluß erzielt. Die zu dieser Zeit im Prozessraum 26 noch herrschende undefinierte Atmosphäre wird sodann durch einen "soft-pump-down-step" abgesaugt und durch eine definierte Prozessgasatmosphäre ersetzt, indem über die Prozessgaseinspeisung 16 diese definierte Gasmischung eingeblasen wird. Dieser Austausch kann ggf. mehrmals wiederholt werden.

Anschließend wird das regelbare Heizelement 20 zugeschaltet und zusammen mit der Heizkassette 9 und dem Heizelement 28 eine gleichmäßige Temperaturverteilung im Prozeßraum eingestellt, gleichzeitig damit wird die Inertgaseinspülung auf geringere Mengen umgestellt. Jetzt kann der eigentliche Prozeßablauf der Gateoxydation mit seinen Zwischenschritten durchgeführt werden. Nach Abschluß der Gateoxydation wird zunächst das Heizelement 20 wieder ausgeschaltet, die Heizkassette 9 und das Heizelement 28 auf einen Wert unter 400°C gefahren und die Inertgasspülung auf großen Durchsatz geregelt. Nach der prozessbedingten, nun nur noch kurzen Wartezeit, wird das Cantileversystem 18-25 mit den Halbleiterscheiben wieder ausgefahren und das Verfahren kann von vorn beginnen.

## Ansprüche

1.Verfahren zur Temperaturbehandlung von in einen Prozeßraum eingebrachten Halbleitermaterialien, **gekennzeichnet durch folgende Verfahrensschritte:**

a) Anfahren der stationären Heizeinrichtungen des Prozeßraumes, je nach Verfahrensführung auf Temperaturen zwischen Raumtemperatur und 350°C und der mobilen Heizeinrichtung auf Raumtemperatur,

b) Inertgasspülung mit hohem Durchsatz und Kühlen des Prozessraumes,      ·

c) Beladen des Cantileversystems mit Halbleiterscheiben, Einfahren in das Prozeßrohr und vakuumdichtes Verschließen desselben,

d) Absaugen der undefinierten Atmosphäre im Prozeßraum mittels eines "soft-pump-down-steps" und Austausch derselben durch eine definierte Prozeßgasmischung,

e) Zuschalten der mobilen Heizeinrichtung und Einstellen gleichmäßiger Temperaturverteilung im Prozeßraum unter gleichzeitiger Umstellung der Inertgasspülung auf geringe Durchsatzmengen,

f) Durchführen des Prozeßablaufes nach rasch durchgeführtem, definiertem Gaswechsel und einem solchen Gaswechsel zum Prozeßende.

g) Abschalten der mobilen Heizeinrichtung nach Abschluß des Prozeßablaufes, Herunterfahren der stationären Heizeinrichtungen auf Werte um 400°C, wahlweise bis auf Raumtemperatur und gleichzeitiges Umschalten der Inertgasspülung auf große Durchsatzmengen,

h) Ausfahren der behandelten Halbleiterscheiben nach prozeßbedingter Wartezeit.

2.Vorrichtung zur Durchführung des Verfahrens nach Anspruch 1 zur Temperaturbehandlung von Halbleitermaterialien in sogen. Diffusionsöfen, insbesondere zur Nieder-, Mittel - und Hochtemperaturbehandlung mittels dieses Diffusionsofens, der ein beladeseitig offenes, doppelwandiges Prozessrohr enthält, mit einer im zwischen den Rohrwandungen verbleibenden Ringraum vorgesehenen Fluidspülung, einer Cantileveranordnung für das Einbringen der zu behandelnden Halbleiterscheiben in das Prozessrohr und einer Prozessgaseinspeisung am hinteren Ende des Prozessrohres mit beladeseitiger Entsorgung dieser Gase, gekennzeichnet durch einen isothermalen Prozessraum (26), der allseitig von Heizelementen (9,20,28) umgeben ist, wovon die Heizkassette (9) das äußere Rohr (1) zylindrisch umgibt, während das beladeseitige Heizelement (20) fahrbar im Cantileversystem (18 bis 25) integriert ist und das Heizelement (28) in dem hinteren, stationären Vestibülblock (7) vorgesehen ist und in diesem Vestibülblock (7) sowohl ein Gasauslaßstutzen (3) als auch ein Inertgasspülsystem (10) mit einem Kranz von Gaseinlaßdüsen (11) in dem Raum zwischen dem inneren Prozessrohr (1) und dem äußeren Rohr (2) angeordnet sind, in dem Vestibülblock (8) das Cantileversystem (18-25) verschiebbar und ein Spülgassystem (10-12) mit einem Kranz von Auslaßdüsen (12) vorgesehen ist.

3.Vorrichtung nach Anspruch 2, **dadurch gekennzeichnet,** daß das bewegliche Heizelement (20) in das Cantileversystem (18-25) integriert ist.

4.Vorrichtung nach Anspruch 2 und 3, **dadurch gekennzeichnet,** daß in dem Raum zwischen den beiden Rohren (1) und (2) eine steuerbare Gasspülung vorgesehen ist.

5.Vorrichtung nach Anspruch 2 bis 4, **dadurch gekennzeichnet,** daß das Prozessrohr (1) im Bereich des Vestibülblockes (8) aufgeweitet und im Bereich des Vestibülblockes (7) zu einem Gasauslaßstutzen (3), der den Vestibülblock (7) durchdringt, verjüngt ist.

6.Vorrichtung nach Anspruch 2 bis 5, **dadurch gekennzeichnet,** daß das Prozessrohr (1) an seinem offenen Ende auf einer Länge von etwa 100 mm oder mehr aufgeweitet ist und an seinem hinteren Ende etwa 100 mm nach dem genutzten Flat-Zonen Abschnitt direkt auf das Maß des Gasauslaßstutzens (3) verjüngt ist.

7.Vorrichtung nach Anspruch 2 bis 6, **dadurch gekenn zeichnet,,** daß die beladeseitige Prozessgaseinspeisung (16) seitlich in dem Ringschlitz zwischen dem aufgeweiteten Ende des Prozessrohres (1) und dem Quarzstutzen (18) vorgesehen und deren Austrittsöffnungen schräg in den Ringschlitz weisen.

8.Vorrichtung nach Anspruch 2 bis 7, **gekennzeichnet durch** ein topfförmiges Heizelement (20) in dem dem Prozeßraum 26 zugewandten Ende des Cantileversystems (18-25), wobei ein Teil des Heizelementes dem Ringschlitz zwischen Prozeßrohr (1) und dem Quarzstutzen (18) benachbart ist und der vordere Teil desselben dem Heizelement (28) gegenüber steht.

9.Vorrichtung nach Anspruch 2 bis 8, **gekennzeichnet durch** ein steckbares Cantileversystem (18-25) in das eine topfförmige Heizeinrichtung (20) integriert ist.

10.Vorrichtung nach Anspruch 2 bis 9, **gekennzeichnet durch** ein Exhaustsystem (4,6) mit Gaseinspeisung.

11.Vorrichtung nach Anspruch 2 bis 10, **dadurch gekenn zeichnet,** daß das Exhaustsystem aus einem Gasausllaßstutzen (3), einem Drei-Wege Ventil (4) und einer Pumpe (5) besteht.

12.Vorrichtung nach Anspruch 2 bis 11, **dadurch gekennzeichnet,** daß unterschiedliche Paddles (19,35,36) in das Cantileversystem (18-25) formschlüssig einsetzbar sind.

Fig.1

Fig. 3

Fig. 2

Fig. 4

Fig. 5